# EUROPEAN PATENT SPECIFICATION

(11) **EP 1 883 073 B1**
(45) Date of publication and mention of the grant of the patent: **03.12.2008**
(21) Application number: 06425537.5
(22) Date of filing: 28.07.2006
(51) Int. Cl.: G11C 7/12, G11C 7/22

(54) **Non-volatile memory device and method of handling a datum read from a memory cell**
Nichtflüchtige Speichervorrichtung und Verarbeitungsverfahren der Leseinformation einer Speicherzelle
Dispositif de mémoire non-volatile et procédé de traitement d'une donnée de lecture d'une cellule de mémoire

(43) Date of publication of application: 30.01.2008
(73) Proprietor: STMicroelectronics Asia Pacific Pte Ltd., Singapore 554574 (SG); Hynix Semiconductor Inc., Ichon-si, Kyoungki-do 467-701 (KR)
(72) Inventor: Park, Jaeseok, Seoul (KR); Song, Dae Sik, Yongin-Si Gyeonggi-Do 446-773 (KR)
(74) Representative: Pellegri, Alberto

(56) References cited:
- US-A- 5 822 260
- US-A1- 2005 117 421
- US-B1- 6 243 312

## Description

### FIELD OF THE INVENTION

This invention relates to memory devices and more particularly to a memory device that includes a global data line driver with an improved architecture for preventing errors while transferring a read datum to a global data line of the memory device.

### BACKGROUND OF THE INVENTION

Non-volatile memory devices organized and functioning in a so-called page mode include a circuit, called "page buffer", dedicated to store data to be programmed in the addressed locations of the memory cell array and to be read from addressed locations of the memory cell array. The page buffer includes a data driver for each memory cell of the page, for outputting a read datum.

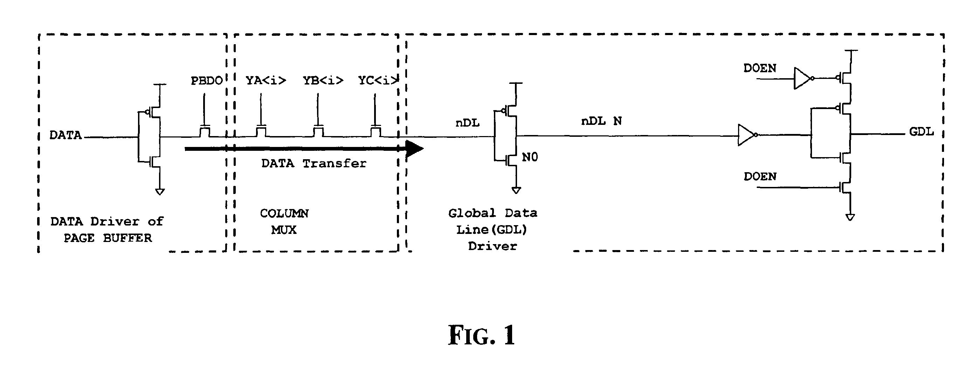

In order to understand the functioning of a page buffer during a read operation, let us refer to the classic scheme of Figure 1. Substantially, during every read operation, the data driver of the page buffer PAGE BUFFER transfers a datum DATA read from the respective memory cell to an output node of the buffer when an enabling signal PBDO is asserted.

The outputs of the data drivers are connected to the inputs of a multiplexer COLUMN MUX, that selects the datum provided by a data driver identified by the address signals YA<i>, YB<i> and YC<i>. This selected datum is transferred to a global data line of the memory device by a global data line driver when a second enabling signal DOEN is asserted.

As depicted in Figure 1, a datum read from a memory cell must propagate through four transistors in cascade for reaching the global data line driver. If this datum is at the supply voltage level, the voltage drops on these transistors may be relevant and the signal nDL could not be at a voltage level sufficient to turn on the transistor N0.

Therefore, in this situation the signal nDL_N would remain high and thus, when the second enabling signal DOEN is asserted, the two-inputs inverter transfers an incorrect datum GDL to the global data line of the memory device. This drawback is likely to occur when the memory is functioning with a relatively low supply voltage (1.8V, for example).

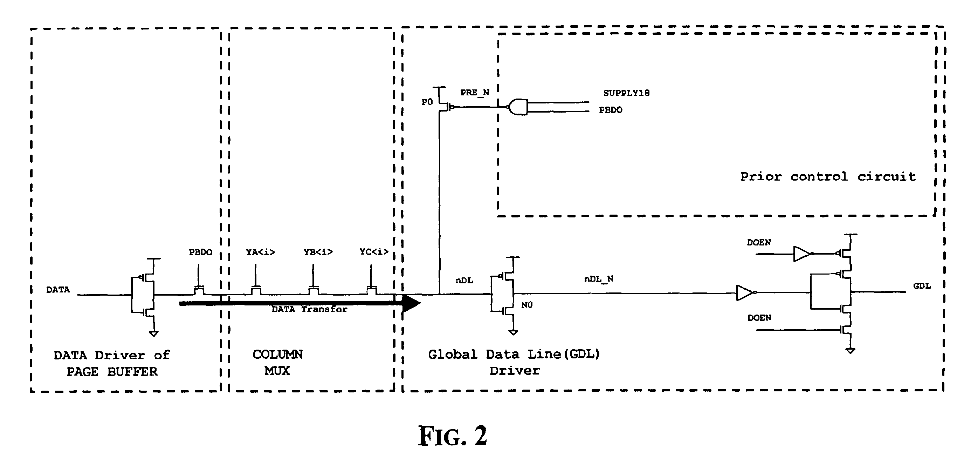

This problem is overcome in modem architectures of memory devices that include a global data line driver, as depicted in Figure 2. In these memory devices, the global data line driver usually includes a pre-charge transistor P0 for connecting/disconnecting the input line of the global data line driver to a supply voltage line of the memory device, switched on by the control signal PRE_N when the enabling signal PBDO of the data driver of the page buffer is asserted and when a low (supply) voltage functioning mode of the memory device is selected. This low voltage functioning mode is usually selected by switching high an externally provided logic command SUPPLY18.

With the above solution, the datum is correctly transferred to the global data line even when functioning in low voltage mode.

Unfortunately, in memory devices that include the circuit of Figure 2 power consumption is found to be greater than in memory devices with the circuit of Figure 1.

### SUMMARY OF THE INVENTION

Extensive investigations carried out by the applicants lead to the conclusion that the memory devices that include the circuit of Figure 2 are more power consuming than the memory devices that include the circuit of Figure 1 because of a small though significant flow of current through the transistor P0 even in stand-by state.

This current is very small even when the datum nDL is low, because the transistor P0 usually has a relatively large resistance even in conduction state. Nonetheless, the investigation carried out lent credibility to attribute such an increase of current absorption to the pre-charge transistor P0 when the datum nDL is low. Indeed, in a memory device there are many global data line drivers, and the currents absorbed by them when the memory is in a stand-by state and the read datum nDL is low add up. This appears to explain the observed increment of power consumption.

This problem is solved according to the method of this invention implemented in the memory device of this invention, by turning on the pre-charge transistor only when, at the same time, the enabling signal PBDO of the page buffer is asserted, a low voltage functioning mode is selected and the memory device is not in a stand-by state, or the memory device is in a stand-by state but the datum nDL read from the memory cell is high. The pre-charge transistor is securely turned off in all other cases.

The invention is defined in the annexed claims.

### BRIEF DESCRIPTION OF THE DRAWINGS

The invention will be described referring to the attached drawings, wherein:
Figure 1 depicts a known global data line driver;
Figure 2 depicts a more recent global data line driver;
Figure 3 depicts a global data line driver of a memory device of this invention;
Figure 4 is a time diagram of the main signals of the memory device of this invention.

### DESCRIPTION OF A PREFERRED EMBODIMENT OF THE INVENTION

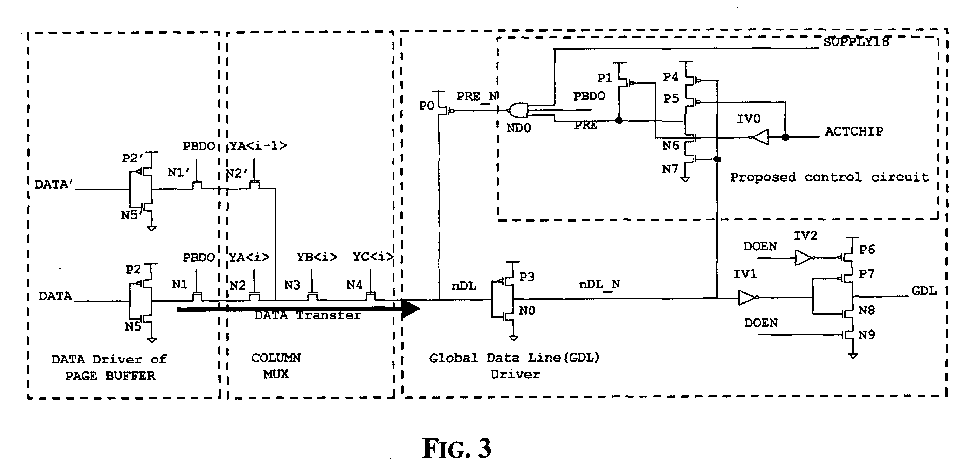

A preferred embodiment of a global data line driver of a memory device of this invention is depicted in Figure 3. Differently from the circuit of Figure 2, the novel global data line driver has a pre-charge control circuit that generates the control signal PRE_N such to turn on the pre-charge transistor P0 only when it is necessary to pre-charge the input line of the global data line driver for the reasons recalled in the introduction.

According to the method of this invention, the transistor P0 is on only when at the same time the external command SUPPLY18 is high (that is the memory device is functioning in a low voltage mode), the enabling signal PBDO is high (that is the page buffer is ready for outputting a read datum) and when an internally generated auxiliary logic signal PRE is high. This PRE signal is high when the stand-by signal ACTCHIP is high (that is the memory device is not in a stand-by state) or when the stand-by signal ACTCHIP is low (that is the memory device is in a stand-by state) but the datum nDL input to the global data line driver is high.

Any skilled person will immediately recognize that the circuit for generating the auxiliary signal PRE may be realized in many other forms, for example using logic gates.

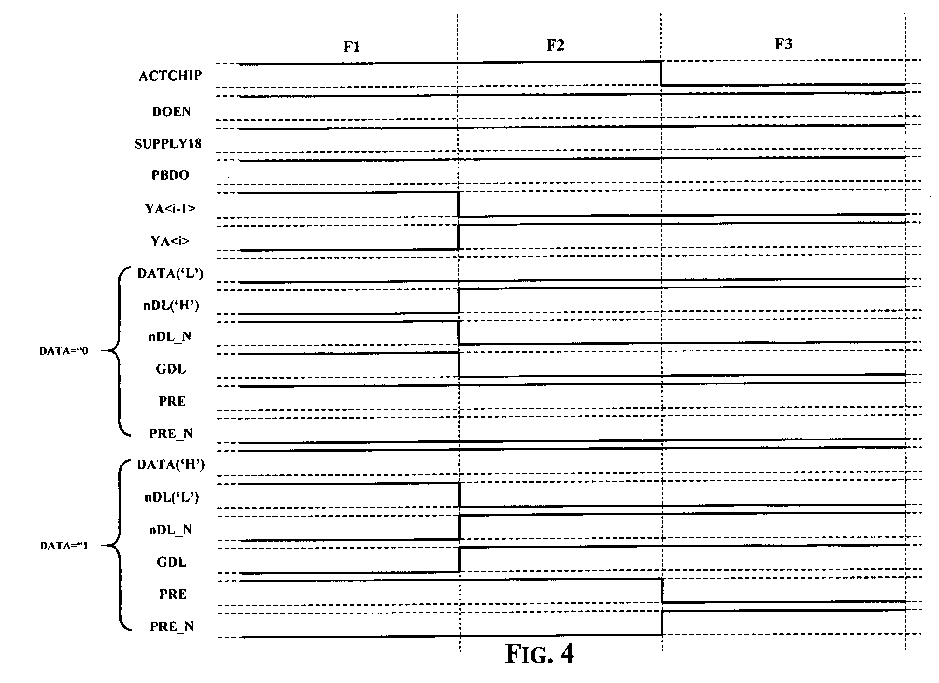

Figure 4 is a sample time diagram of the main signals of the circuit of Figure 3 for a read operation during which the memory device switches from an active state to stand-by state.
**Step F1:** DATA is prepared in data driver of page buffer (P2 PMOS and N5 NMOS). PBDO signal is "1"(VDD). YB<i> and YC<i> signals are also "1" and they remain at the high logic level for all steps. The address signal YA<i> is "0" (GND), thus data transfer from the i-th page buffer is not carried out. By contrast, the address signal YA<i-1> is "1", thus the (i-1)-th page buffer is selected (P2' PMOS and N5' NMOS). The selection of page buffers is sequential, thus the signals YA<i-1> and YA<i> cannot be both active.
   The read datum DATA' is transferred to the input line nDL of the global data line driver through the NMOS transistors N1', N2', N3 and N4. The signal SUPPLY18 signal is "1" during all steps for selecting a low voltage functioning mode. The memory device is carrying out a read operation, thus it is in a active state (the signal ACTCHIP is "1"). The second enabling signal DOEN is "1" and the global data line GDL is driven according to the value of DATA by the global data line driver.
   If DATA is "0" and DATA' is "1", thus the line nDL is "0", its inverted replica nDL_N is "1" and the datum output on the global data line GDL is "1". If DATA is "1" and DATA' is "0", the line nDL is "1", its inverted replica nDL_N is "0" and the datum output on the global data line GDL is "0".
   Because the signal ACTCHIP is "1", the auxiliary signal PRE is "1" regardless the value of DATA', thus PRE_N node is "0" and the PMOS transistor P0 is in a conduction state.
**Step F2:** the address bit YA<i-1> is "0" and YA<i> is "1" and these levels are maintained constant during step F3. The datum DATA is transferred through the NMOS transistors N1, N2, N3 and N4 and the lines nDL, nDL_N and GDL are charged to the opposite values.
   The auxiliary signal PRE and the control signal PRE_N are kept at their values from step F1. Therefore, the PMOS transistor P0 is still on. This helps charging the nDL line in case the DATA is 'L', that is nDL 'H'.
**Step F3:** the selection signal ACTCHIP switches to "0", thus the memory device enters a stand-by state. The auxiliary signal PRE is thus an inverted replica of the signal nDL_N, because the PMOS transistor P4 or the NMOS transistor N7 are in a conduction state together with the PMOS transistor P5 and the NMOS transistor N6.
   If DATA is "0", the nDL signal is "1" and nDL_N is "0", thus the auxiliary signal PRE is "1", as in Step F2. The control signal PRE_N is "0" and the PMOS transistor P0 is still in a conduction state and charges the line nDL. In practice, the line nDL is latched at the value "1".
   If DATA is "1", the nDL signal is "0" and nDL_N is "1", thus the auxiliary signal PRE switches from "1" to "0" and the control signal PRE_N switches from "0" to "1". Therefore, the PMOS transistor P0 is turned off and there is no current consumption.

With the novel global data line driver of this invention the pre-charge transistor P0 is kept in an off state when the memory device is in stand-by and the datum nDL is low. Comparative tests have demonstrated that the power consumption of a memory device equipped with a so conditioned pre-charge transistor according to this invention is significantly reduced during stand-by state.

## Claims

1. A non-volatile memory device functioning in page mode, comprising:
a page buffer including a plurality of data output drivers, all enabled by an enabling signal (PBDO) distributed in parallel for outputting a datum read from an accessed page of the memory,
a selection multiplexer controlled by address signals (YA, YB, YC) for selecting the datum present at the output of one of said data drivers,
a global data line driver coupled to the output of said multiplexer for transferring the selected datum when a second enabling signal (DOEN) is asserted, said global data line driver comprising:
a pre-charge transistor (P0) turned on by a pre-charge control signal (PRE_N), that connects the input line of the global data line driver to a supply line of the memory device,
a pre-charge control circuit that generates said pre-charge control signal (PRE_N) for turning on the pre-charge transistor (P0) when said first enabling signal (PBDO) is asserted and at the same time a command signal (SUPPLY18) is asserted for selecting a low voltage functioning mode of the memory device,
**characterized in that** said pre-charge control circuit is input with said first enabling signal (PBDO), said command signal (SUPPLY18), a replica of said read datum and a stand-by signal (ACTCHIP) for setting the memory device in a stand-by state, and generates said pre-charge control signal (PRE_N) for turning on the pre-charge transistor (P0) only when the following conditions are all verified:
- said first enabling signal (PBDO) is asserted;
- said command signal (SUPPLY18) is asserted;
- the memory device is not in a stand-by state, or the memory device is in a stand-by state but the datum on the input line of the global data line driver is at a high logic level.

2. The non-volatile memory device of claim 1, wherein said global data line driver comprises:
a first inverter that receives an input line the datum (nDL) selected by said selection multiplexer and generates on an internal line (nDL_N) of the global data line driver an inverted replica thereof;
a second inverter in cascade with the first inverter and controlled by a second enabling signal (DOEN), that transfers said inverted replica (nDL_N) to an output line (GDL) of said global data line driver.

3. The non-volatile memory device of claim 2, wherein said circuit means comprise:
a two-input inverter that receives said inverted replica (nDL_N) and the stand-by signal (ACTCHIP) for setting the memory device in a stand-by state when it assumes a null logic value, and that generates an auxiliary signal (PRE) on an output node thereof, that is:
- logically high when said stand-by signal (ACTCHIP) is low together with said inverted replica (nDL_N),
- logically low when said stand-by signal (ACTCHIP) is low and said inverted replica (nDL_N) is high,
- left floating when said stand-by signal (ACTCHIP) is high;
a controlled switch that connects the output node of the two-input inverter to a supply line of the memory device when said stand-by signal (ACTCHIP) is high;
a NAND gate input with said auxiliary signal (PRE), said first enabling signal (PBDO) and a logic signal that is high when a low voltage functioning mode of the memory device is selected, that generates said control signal (PRE_N).

4. A method of handling a datum read from a cell of a non-volatile memory device functioning in page mode that comprises:
a page buffer including a plurality of data drivers, all enabled by an enabling signal (PBDO) distributed in parallel for outputting a datum read from an accessed page of the memory,
a selection multiplexer controlled by address signals (YA, YB, YC) for selecting the datum present at the output of one of said data drivers,
a global data line driver coupled to the output of said multiplexer for transferring the selected datum when a second enabling signal (DOEN) is asserted, said global data line driver comprising:
- a pre-charge transistor (P0) turned on by a pre-charge control signal (PRE_N), that connects the input line of the global data line driver to a supply line of the memory device,
- a pre-charge control circuit that generates said pre-charge control signal (PRE_N) for turning on the pre-charge transistor (P0) when said first enabling signal (PBDO) is asserted and at the same time a command signal (SUPPLY18) is asserted for selecting a low voltage functioning mode of the memory device,
**characterized in that** the method comprises the step of pre-charging said input line of the first inverter with the supply voltage of the memory device only when, at the same time,
- said first enabling signal (PBDO) is asserted;
- said command signal (SUPPLY 18) is asserted;
- the memory device is not in a stand-by state, or the memory device is in a stand-by state but the datum on the input line of the global data line driver is at a high logic level.

## Patentansprüche

1. Eine nichtflüchtige Speichervorrichtung, die in Page Mode funktioniert und jeweils folgendes umfasst:
einen PAGE BUFFER, der eine Vielzahl von Datenausgabe-Treibern einschließt, alle durch ein Aktivierungs-Signal (PBDO) aktiviert, das zwecks Ausgabe einer Angabe parallel angeordnet ist, die von einer adressierten Seite des Speichers gelesen wird,
einen Wahl-Multiplexer, der durch Adress-Signale (YA, YB, YC) gesteuert wird, um die Angabe zu wählen, die am Ausgang eines der genannten Datentreibers vorliegt,
einen Global Data Line-Treiber, der mit dem Ausgang des gewählten Multiplexers für die Übertragung der genannten Angabe gekoppelt ist, wenn ein zweites Aktivierungssignal (DOEN) bestätigt ist, wobei der genannte Global Data Line-Treiber folgendes umfasst:
- einen Vorlade-Transistor (P0), der durch ein Vorlade-Steuersignal (PRE_N) eingeschaltet wird, welcher die Eingangsleitung des Global Data Line-Treibers mit einer Speiseleitung der Speichervorrichtung verbindet,
- einen Vorlade-Steuerschaltkreis, der das genannte Vorlade-Steuersignal (PRE_N) zur Einschaltung des Vorlade-Transistors (P0) erzeugt, wenn das genannte erste Aktivierungssignal (PBDO) und gleichzeitig ein Steuersignal (SUPPLY18) zwecks Wahl einer Niedervolt-Betriebsweise der Speichervorrichtung bestätigt ist,
**dadurch gekennzeichnet, dass** der genannte Vorlade-Steuerschaltkreis am Eingang das genannte erste Aktivierungssignal (PBDO), das genannte Steuersignal (SUPPLY18), eine Wiederholung der genannten gelesenen Angabe und ein Stand-by-Signal (ACTCHIP) empfängt, um die Speichervorrichtung in einen Stand-by-Zustand zu versetzen, und das genannte Vorlade-Steuersignal (PRE_N) erzeugt, um den Vorlade-Transistor (P0) nur dann einzuschalten, wenn sämtliche folgenden Zustände überprüft wurden:
- das genannte erste Aktivierungssignal (PBCO) bestätigt ist;
- das genannte Steuersignal (SUPPLY18) bestätigt ist;
- die Speichervorrichtung befindet sich nicht im Stand-by-Zustand, bezw. die Speichervorrichtung befindet sich zwar im Stand-by-Zustand, aber die Angabe auf der Eingangsleitung des Global Data Line-Treibers befindet sich auf einem hohen logischen Niveau.

2. Die nichtflüchtige Speichervorrichtung nach Anspruch 1, wobei der genannte Global Data-Line-Treiber folgendes umfasst:
einen ersten Inverter, der auf einer Eingangsleitung die Angabe (nDL) empfängt, die durch den genannten Wahl-Multiplexer gewählt wird, und auf einer internen Leitung (nDL_N) des Global Data Line-Treibers deren umgekehrte Wiederholung erzeugt;
einen zweiten Inverter in Kaskade mit dem ersten Inverter und gesteuert durch ein zweites Aktivierungssignal (DOEN), das die genannte umgekehrte Wiederholung (nDL_N) auf eine Ausgangsleitung (GDL) des genannten Global Data Line-Treibers überträgt.

3. Die nichtflüchtige Speichervorrichtung aus Anspruch 2, wobei die genannten Schaltkreiselemente jeweils folgendes umfassen:
einen Inverter mit zwei Eingängen, der die genannte umgekehrte Wiederholung (nDL_N) und das Stand-by-Signal (ACTCHIP) empfängt, um die Speichervorrichtung in einen Stand-by-Zustand zu versetzen, wenn sie einen Null Logic-Wert aufnimmt, und der ein Hilfs-Signal (PRE) an einem Ausgangs-Knotenpunkt davon erzeugt, und zwar:
- logisch hoch, wenn das genannte Stand-by-Signal (ACTCHIP) zusammen mit der genannten umgekehrten Wiederholung (nDL_N) niedrig ist;
- logisch niedrig, wenn das genannte Stand-by-Signal (ACTCHIP) niedrig und die genannte umgekehrte Wiederholung (nDL_N) hoch ist;
- fließend, wenn das genannte Stand-by-Signal (ACTCHIP) hoch ist:
einen gesteuerten Schalter, der den Ausgangs-Knotenpunkt des Inverters mit zwei Eingängen mit jeweils einer Speiseleitung der Speichervorrichtung verbindet, wenn das genannte Stand-by-Signal (ACTCHIP) hoch ist;
einen NAND-Gate der das genannte Hilfssignal (PRE), das genannte erste Aktivierungssignal (PBDO) und ein logisches Signal, das hoch ist, wenn eine Niedervolt-Betriebsweise der Speichervorrichtung gewählt wird, die das genannte Steuersignal (PRE_N) erzeugt.

4. Eine Methode zur Verarbeitung einer Angabe, die von einer Zelle der nichtflüchtigen, im Page Mode funktionierenden Speichervorrichtung abgelesen wird, welche folgendes umfasst:
Einen Page Buffer, der eine Vielzahl von Daten-Treibern einschließt, alle aktiviert durch ein Aktivierungssignal (PBDO), parallel angeordnet zwecks Ausgabe einer Angabe, die von einer adressierten Seite des Speichers gelesen wird;
einen Wahl-Multiplexer, der durch Adress-Signale (YA, YB, YC) gesteuert wird, um die am Ausgang eines der genannten Daten-Treiber vorliegende Angabe zu wählen;
einen Global Data Line-Treiber, der mit dem Ausgang des genannten Multiplexers zur Übertragung der gewählten Angabe gekoppelt ist, wenn ein zweites Aktivierungssignal (DOEN) bestätigt ist, wobei der genannte Global Data Line-Treiber jeweils folgendes umfasst:
- einen Vorlade-Transistor (P0), der durch ein Vorlade-Steuersignal (PRE_N) eingeschaltet wird, welcher die Eingangsleitung des Global Data Line-Treibers mit einer Speiseleitung der Speichervorrichtung verbindet;
- einen Vorlade-Steuerschaltkreis, der das genannte Vorlade-Steuersignal (PRE_N) zur Einschaltung des Vorlade-Transistors (P0) erzeugt, wenn das genannte erste Aktivierungssignal (PBDO) und gleichzeitig ein Steuersignal (SUPPLY18) bestätigt sind, um eine Niedervolt-Betriebsweise der Speichervorrichtung zu wählen;
**dadurch gekennzeichnet, dass** die Methode den Schritt der Vorladung der genannten Eingangsleitung des ersten Inverters mit der Speisespannung der Speichervorrichtung umfasst, und zwar nur dann, wenn gleichzeitig
- das gennante erste Aktivierungssignal (PBDO) bestätigt ist;
- das genannte Steuersignal (SUPPLY18) bestätigt ist;
die Speichervorrichtung sich nicht im Stand-by-Zustand befindet, beziehungsweise die Speichervorrichtung sich zwar im Stand-by-Zustand befindet, die Angabe auf der Eingangsleitung des Global Data Line-Treibers sich jedoch auf einem hohen logischen Niveau befindet.

## Revendications

1. Dispositif de mémoire non volatile fonctionnant en mode page, qui comprend :
une mémoire tampon de recherche qui comprend une pluralité de circuits de pilotage de production de données, étant tous activés par un signal d'activation (PBDO) distribué en parallèle pour produire à la sortie une donnée lue à partir d'une page adressée de la mémoire,
un multiplexeur de sélection commandé par des signaux d'adressage (YA, YB, YC) pour sélectionner la donnée présente à la sortie d'un desdits circuits de pilotage de données,
un circuit de pilotage de ligne de données globale couplé à la sortie dudit multiplexeur pour transférer la donnée sélectionnée quand un deuxième signal d'activation (DOEN) est affirmé, ledit circuit de pilotage de ligne de données globale qui comprend :
un transistor de précharge (P0) allumé par un signal de commande de la précharge (PRE_N), qui connecte la ligne d'entrée du circuit de pilotage de ligne de données globale à une ligne d'alimentation du dispositif de mémoire,
un circuit de commande de la précharge qui génère ledit signal de commande de la précharge (PRE_N) pour allumer le transistor de précharge (P0) quand ledit premier signal d'activation (PBDO) est affirmé et, dans un même temps, un signal de commande (SUPPLY18) est affirmé pour sélectionner un mode de fonctionnement à basse tension du dispositif de mémoire,
**caractérisé en ce que**
ledit circuit de commande de la précharge reçoit en entrée ledit premier signal d'activation (PBDO), ledit signal de commande (SUPPLY18), une réplique de ladite donnée lue et un signal de stand-by (ACTCHIP) pour mettre le dispositif de mémoire en stand-by, et génère ledit signal de commande de la précharge (PRE_N) pour allumer le transistor de précharge (P0) uniquement quand les conditions suivantes se sont toutes produites :
- ledit premier signal d'activation (PBDO) est affirmé ;
- ledit signal de commande (SUPPLY18) est affirmé ;
- le dispositif de mémoire n'est pas en stand-by, ou le dispositif de mémoire est en stand-by mais la donnée sur la ligne d'entrée du circuit de pilotage de ligne de données globale est à un niveau logique élevé.

2. Dispositif de mémoire non volatile selon la revendication 1, où ledit circuit de pilotage de ligne de données globale comprend :
un premier inverseur qui reçoit sur une ligne d'entrée la donnée (nDL) sélectionnée par ledit multiplexeur de sélection et génère, sur une ligne interne (nDL_N) du circuit de pilotage de ligne de données globale, une réplique invertie de celle-ci ;
un deuxième inverseur en cascade avec le premier inverseur et commandé par un deuxième signal d'activation (DOEN), qui transfère ladite réplique invertie (nDL_N) à une ligne de sortie (GDL) dudit circuit de pilotage de ligne de données globale.

3. Dispositif de mémoire non volatile selon la revendication 2, où lesdits dispositifs du circuit comprennent :
un inverseur à deux entrées qui reçoit ladite réplique invertie (nDL_N) et le signal de stand-by (ACTCHIP) pour mettre le dispositif de mémoire en stand-by quand il prend une valeur logique nulle, et qui génère un signal auxiliaire (PRE) sur un noeud de sortie de celui-ci, qui est :
- logiquement élevé quand ledit signal de stand-by (ACTCHIP) avec ladite réplique invertie (nDL_N) est bas,
- logiquement bas quand ledit signal de stand-by (ACTCHIP) est bas et ladite réplique invertie (nDL_N) est élevée,
- flottant quand ledit signal de stand-by (ACTCHIP) est élevé ;
un commutateur commandé qui connecte le noeud de sortie de l'inverseur à deux entrées à une ligne d'alimentation du dispositif de mémoire quand ledit signal de stand-by (ACTCHIP) est élevé ;
une porte NAND recevant ledit signal auxiliaire (PRE), ledit premier signal d'activation (PBDO) et un signal logique qui est élevé quand un mode de fonctionnement à basse tension du dispositif de mémoire est sélectionné, qui génère ledit signal de commande (PRE_N).

4. Méthode de traitement d'une donnée lue à partir d'une cellule d'un dispositif de mémoire non volatile fonctionnant en mode page qui comprend :
une mémoire tampon de recherche qui comprend une pluralité de circuits de pilotage de données, étant tous activés par un signal d'activation (PBDO) distribué en parallèle pour produire à la sortie une donnée lue à partir d'une page adressée de la mémoire,
un multiplexeur de sélection commandé par des signaux d'adressage (YA, YB, YC) pour sélectionner la donnée présente à la sortie d'un desdits circuits de pilotage de données,
un circuit de pilotage de ligne de données globale couplé à la sortie dudit multiplexeur pour transférer la donnée sélectionnée quand un deuxième signal d'activation (DOEN) est affirmé, ledit circuit de pilotage de ligne de données globale se composant de :
- un transistor de précharge (P0) allumé par un signal de commande de la précharge (PRE_N), qui connecte la ligne d'entrée du circuit de pilotage de ligne de données globale à une ligne d'alimentation du dispositif de mémoire,
- un circuit de commande de la précharge qui génère ledit signal de commande de la précharge (PRE_N) pour allumer le transistor de précharge (P0) quand ledit premier signal d'activation (PBDO) est affirmé et, dans un même temps, un signal de commande (SUPPLY18) est affirmé pour sélectionner un mode de fonctionnement à basse tension du dispositif de mémoire,
**caractérisée en ce que** la méthode comprend la phase de précharge de ladite ligne d'entrée du premier inverseur avec la tension d'alimentation du dispositif de mémoire uniquement quand, dans un même temps,
- ledit premier signal d'activation (PBDO) est affirmé ;
- ledit signal de commande (SUPPLY18) est affirmé ;
- le dispositif de mémoire n'est pas en stand-by, ou le dispositif de mémoire est en stand-by mais la donnée sur la ligne d'entrée du circuit de pilotage de ligne de données globale est à un niveau logique élevé.
